# DEMANDE DE BREVET EUROPEEN

(11) **EP 4 571 164 A1**
(43) Date de publication de la demande: **18.06.2025**
(21) Numéro de dépôt: 24219965.1
(22) Date de dépôt: 13.12.2024
(51) Int. Cl.: F16L 27/02, F16L 29/04, H05K 7/20

(54) **DISPOSITIF DE RACCORDEMENT FLUIDIQUE ET ENSEMBLE DE RACCORDEMENT FLUIDIQUE COMPRENANT UN TEL DISPOSITIF DE RACCORDEMENT FLUIDIQUE**

(30) Priorité: 15.12.2023 FR 2314303
(71) Demandeur: Staubli Faverges, 74210 Faverges-Seythenex (FR)
(72) Inventeur: MARQUES BARROCA, Serafim, 73200 Albertville (FR); DURIEUX, Christophe, 73200 Gilly sur Isere (FR)
(74) Mandataire: Lavoix

(57) **Abrégé**

La présente invention concerne dispositif de raccordement fluidique (2), comprenant une bride (23), et un embout (25) traversé par un canal interne distal (251) et configuré pour être accouplé fluidiquement à un dispositif de raccordement complémentaire (3). L'embout, monté dans la bride avec possibilité d'inclinaison par rapport à la bride (23), comporte une extrémité arrière (252), et une extrémité avant (259). L'invention comprend également une tige (27) comportant un canal interne intermédiaire (271), une extrémité avant, montée en coopération étanche avec l'extrémité arrière de l'embout avec possibilité d'inclinaison de la tige par rapport à l'embout et par rapport à la bride pour une communication fluidique entre le canal interne distal (251) de l'embout et le canal interne intermédiaire de la tige, et une extrémité arrière (273) pour une communication fluidique entre un conduit interne proximal (213) et le canal interne intermédiaire.

## Description

La présente invention concerne un dispositif de raccordement fluidique et un ensemble de raccordement fluidique comprenant un tel dispositif de raccordement fluidique.

Dans le domaine des circuits de thermorégulation, en particulier ceux conçus pour refroidir des installations de serveurs informatiques, utilisant tous types de fluide, en particulier un fluide caloporteur, à une pression maximale de 16 bar, il est connu de raccorder, à l'aide d'un ensemble de raccordement, les différents éléments du circuit de thermorégulation de manière à établir entre eux une connexion fluidique pour faire circuler ledit fluide dans le circuit de thermorégulation.

L'ensemble de connexion fluidique connu comprend au moins un premier élément de raccord fluidique, par exemple un élément mâle, et au moins un deuxième élément de raccord fluidique complémentaire, par exemple un élément femelle, étant agencé pour être accouplé avec le premier élément de raccord fluidique.

Cependant, à cause des tolérances de fabrication et d'assemblage, le premier élément de raccord de l'ensemble de connexion et le deuxième élément complémentaire ne sont en général pas parfaitement alignés, ce qui augmente les efforts d'accouplement, le risque de coincement et/ou l'usure lors de la connexion.

Il est connu de CN102691844 d'utiliser un premier embout de l'ensemble de raccordement qui comprend une soupape mobile dans le corps d'embout et une extrémité arrière du corps d'embout dotée d'une surface sphérique convexe. La surface sphérique convexe coopère de manière étanche avec un anneau sphérique. Un anneau de retenue bloque le corps d'embout et l'empêche de se retirer de la base de montage. Un espace de débattement est prévu entre la surface de la paroi interne de la base de montage et respectivement l'anneau sphérique, l'anneau de retenue, la surface périphérique extérieure du corps d'embout et si bien que le corps d'embout peut s'incliner par rapport à l'anneau sphérique tandis que l'anneau sphérique peut se déplacer radialement par rapport à la base de montage.

Il est également connu de EP4155596 d'utiliser une bride à débattement dans laquelle sont logés deux premiers embouts de l'ensemble de connexion, chaque premier embout étant inclinable par rapport à la bride et pouvant prendre une configuration désalignée par rapport à la bride pour tolérer un défaut d'alignement angulaire lors de l'accouplement avec un deuxième embout de raccordement associé de l'ensemble de raccordement. Cependant, les joints d'étanchéité, disposés entre le support de l'ensemble de connexion et la surface de débattement de la bride, augmentent le frottement causé par le mouvement de débattement de la bride ce qui augmente les efforts de connexion.

Le but de l'invention est alors de proposer un dispositif de raccordement fluidique qui tolère un défaut d'alignement angulaire et/ou radial au début de l'accouplement et qui limite les efforts d'accouplement, notamment dus au débattement de la bride.

A cet effet, l'invention a pour objet un dispositif de raccordement fluidique, comprenant :
- une bride, formant une surface axiale avant externe et une surface axiale arrière externe, opposée à la surface axiale avant externe, la surface axiale avant externe et la surface axiale arrière externe étant annulaires, perpendiculaires à un axe longitudinal central de la bride, et tournées respectivement suivant une direction avant parallèle à l'axe longitudinal de la bride, suivant une direction arrière opposée à la direction avant ; et
- au moins un embout centré sur un axe longitudinal, traversé par un canal interne distal et configuré pour être accouplé fluidiquement à un dispositif de raccordement complémentaire, l'embout comportant :
   ∘ une extrémité arrière, montée dans un logement interne de la bride, et
   ∘ une extrémité avant, disposée au-delà de la surface axiale avant externe de la bride selon la direction avant;
   l'embout étant monté dans la bride avec possibilité d'inclinaison par rapport à la bride et avec possibilité de déplacement limité par rapport à la bride selon les directions avant et arrière et selon toutes les directions radiales à l'axe longitudinal de la bride ; l'extrémité arrière de l'embout étant solidaire en déplacement avec la bride radialement à l'axe longitudinal, aux jeux radiaux près entre une collerette externe de l'embout et la bride, la collerette externe étant cylindrique et disposée au niveau de l'extrémité arrière de l'embout,
- un couvercle, qui forme une surface axiale arrière apte à coopérer avec la surface axiale avant externe de la bride pour guider un déplacement de la bride par rapport au couvercle radialement à l'axe longitudinal de la bride,

Selon l'invention, le dispositif de raccordement fluidique comprend en outre une tige comportant :
- un canal interne intermédiaire;
- une extrémité avant, montée en coopération étanche avec l'extrémité arrière de l'embout avec possibilité d'inclinaison de la tige par rapport à l'embout et par rapport à la bride, l'extrémité avant de la tige étant solidaire de l'extrémité arrière de l'embout le long de l'axe longitudinal de l'embout, aux jeux de fonctionnement près, et l'extrémité avant de la tige étant solidaire de l'extrémité arrière de l'embout radialement à l'axe longitudinal de l'embout, aux jeux de fonctionnement près, pour une communication fluidique entre le canal interne distal de l'embout et le canal interne intermédiaire de la tige ; et
- une extrémité arrière disposée au-delà de la bride, suivant la direction arrière pour une communication fluidique entre le canal interne intermédiaire de la tige et un conduit interne proximal, par rapport auquel le couvercle est destiné à être fixe ;
le canal interne intermédiaire traversant la tige depuis l'extrémité avant de la tige jusqu'à l'extrémité arrière de la tige.

Grâce à l'invention, en particulier grâce à la présence de la tige et au raccordement étanche entre le canal interne distal et le canal interne intermédiaire qui forment un passage de fluide étanche depuis l'extrémité avant de l'embout jusqu'à l'extrémité arrière de la tige, la bride n'intervient plus dans l'étanchéité du raccordement. En particulier, lorsque la bride est montée dans un support, l'invention permet d'isoler fluidiquement la bride du canal interne distal de l'embout et du canal interne intermédiaire de la tige et rend inutile le montage d'un joint entre la surface axiale avant de la bride et le support ou entre la surface axiale arrière de la bride et le support. Cette absence de joint permet de limiter les frottements lors du déplacement radial de la bride dans le support et ainsi de limiter les efforts de connexion.

Suivant d'autres aspects avantageux de l'invention, le dispositif de raccordement fluidique comprend une ou plusieurs des caractéristiques suivantes, prises isolément ou suivant toutes les combinaisons techniquement possibles :
- l'extrémité avant de la tige est reçue de manière étanche dans un logement interne de l'extrémité arrière de l'embout,
- la tige comprend un corps tubulaire et une bague avant qui entoure de manière étanche le corps tubulaire de la tige pour former l'extrémité avant de la tige et qui, dans une configuration montée de la tige dans le logement interne présente une surface externe en portion de sphère qui coopère par complémentarité de formes avec une surface interne en portion de sphère du logement interne de l'extrémité arrière de l'embout et est apte à venir en butée arrière contre une surface de butée formée par la surface interne partiellement sphérique du logement interne et délimitée par une ouverture de l'embout débouchant sur l'arrière de l'embout et, sur l'avant, dans le logement interne de l'embout, ladite ouverture s'étendant, dans un plan perpendiculaire à l'axe longitudinal de l'embout, sur une section plus grande que la section externe de la bague avant, prise dans un plan longitudinal passant par l'axe longitudinal de l'embout et en configuration montée de la tige dans le logement interne,
- aucun joint d'étanchéité n'est interposé directement entre la bride et l'embout.
- un premier ressort, qui est interposé entre la bride et l'embout et qui rappelle élastiquement l'embout par rapport à la bride, vers une position où la collerette externe de l'embout est en butée avant contre une surface interne de la bride délimitant le logement interne, et l'axe longitudinal de la bride est coaxial avec l'axe longitudinal de l'embout,
- un corps de support, avec lequel est fixé le couvercle et qui forme une surface axiale avant qui délimite, avec la surface axiale arrière du couvercle, un logement recevant la bride, la surface axiale avant étant apte à guider le déplacement de la bride par rapport au corps de support, radialement à l'axe longitudinal de la bride, par coopération avec la surface axiale arrière externe de la bride et le conduit interne proximal, qui est centré sur un axe longitudinal central, qui débouche dans le logement du corps de support selon la direction avant, et qui reçoit l'extrémité arrière de la tige pour la communication fluidique entre le canal interne intermédiaire de la tige et le conduit interne proximal,
- un dispositif de recentrage, rappelant élastiquement la bride vers une position où l'axe longitudinal de la bride est coaxial avec l'axe longitudinal central du conduit interne proximal,
- le dispositif de recentrage comprend une bague de recentrage, agencée dans le conduit interne proximal et mobile en translation par rapport au corps de support suivant l'axe longitudinal central du conduit interne proximal et un deuxième ressort, repoussant une surface avant de la bague de recentrage en contact avec une surface arrière de la bride et la surface arrière de la bride est une surface tronconique centrée sur l'axe longitudinal de la bride et/ou la surface avant de la bague de recentrage est une surface tronconique centrée sur l'axe longitudinal central du conduit interne proximal,
- un joint d'étanchéité, solidaire de la tige selon l'axe longitudinal central du conduit interne proximal et en contact étanche avec une surface radiale interne du conduit interne proximal du corps de support,
- l'extrémité arrière de la tige est montée dans un coulisseau de manière étanche, avec possibilité d'inclinaison par rapport au coulisseau, l'extrémité arrière de la tige est solidaire du coulisseau le long de l'axe longitudinal du conduit interne proximal, aux jeux de fonctionnement près, et l'extrémité arrière de la tige est solidaire du coulisseau radialement à un axe longitudinal de la tige, aux jeux de fonctionnement près, et le coulisseau comporte une surface radiale externe cylindrique et est monté dans le conduit interne proximal avec possibilité de déplacement par rapport au corps de support le long de l'axe longitudinal central du conduit interne proximal,
- le canal interne intermédiaire de la tige est délimité par une surface interne, tronconique évasée vers l'extérieur du canal interne intermédiaire à l'extrémité avant de la tige, respectivement à l'extrémité arrière de la tige,
- une longueur de la tige, mesurée entre l'extrémité avant et l'extrémité arrière de la tige selon un axe longitudinal de la tige, est strictement inférieure à une longueur de l'embout, mesurée entre l'extrémité avant et l'extrémité arrière de l'embout selon l'axe longitudinal de l'embout,
- une soupape disposée dans le canal interne distal de l'embout, qui est mobile par rapport à l'embout le long de l'axe longitudinal de l'embout entre une position avancée de fermeture du canal interne distal et une position reculée d'ouverture du canal interne distal

L'invention a également pour objet un ensemble de raccordement fluidique comprenant le dispositif de raccordement fluidique tel que défini ci-avant et le dispositif de raccordement complémentaire, configuré pour s'accoupler avec l'embout du dispositif de raccordement fluidique.

De préférence, le dispositif de raccordement complémentaire comprend un corps principal, comprenant une surface radiale interne étagée, l'embout comprend une surface radiale externe étagée et la surface radiale interne étagée et la surface radiale externe étagée coopèrent, en configuration accouplée, par complémentarité de formes.

L'invention apparaîtra plus clairement à la lecture de la description qui va suivre, donnée uniquement à titre d'exemple non limitatif, et faite en référence aux dessins dans lesquels :
[Fig. 1] la figure 1 est une coupe longitudinale d'un ensemble de raccordement fluidique comprenant un dispositif de raccordement et d'un dispositif de raccordement complémentaire selon un premier mode de réalisation de l'invention, les dispositifs de raccordement étant représentés dans une configuration de début d'accouplement entre les deux dispositifs.
[Fig. 2] La figure 2 est une coupe transversale de l'ensemble de raccordement fluidique de la figure 1 selon le plan de coupe II-II montré sur la figure 1.
[Fig. 3] La figure 3 est une coupe transversale de l'ensemble de raccordement fluidique de la figure 1 selon le plan de coupe III-III montré sur la figure 1.
[Fig. 4] La figure 4 est une coupe longitudinale de l'ensemble de raccordement fluidique de la figure 1, les dispositifs de raccordement étant représentés dans une première configuration intermédiaire d'accouplement.
[Fig. 5] La figure 5 est une coupe longitudinale de l'ensemble de raccordement fluidique des figures précédentes, les dispositifs de raccordement étant représentés dans une deuxième configuration intermédiaire d'accouplement.
[Fig. 6] La figure 6 est une vue en coupe longitudinale de l'ensemble de raccordement fluidique des figures précédentes, les dispositifs de raccordement étant représentés dans une configuration accouplée.
[Fig. 7] La figure 7 est vue en coupe longitudinale d'un ensemble de raccordement fluidique comprenant un dispositif de raccordement et d'un dispositif de raccordement complémentaire selon un deuxième mode de réalisation de l'invention, les dispositifs de raccordement étant représentés dans une configuration de début d'accouplement entre les deux dispositifs.
[Fig. 8] La figure 8 est une vue en coupe longitudinale de l'ensemble de raccordement fluidique de la figure 7, les dispositifs de raccordement étant représentés dans une première configuration intermédiaire d'accouplement.
[Fig. 9] La figure 9 est une vue en coupe longitudinale de l'ensemble de raccordement fluidique de la figure 7, les dispositifs de raccordement étant représentés dans une deuxième configuration intermédiaire d'accouplement.
[Fig. 10] La figure 10 est une vue en coupe longitudinale de l'ensemble de raccordement fluidique de la figure 7, les dispositifs de raccordement étant représentés dans une configuration accouplée.

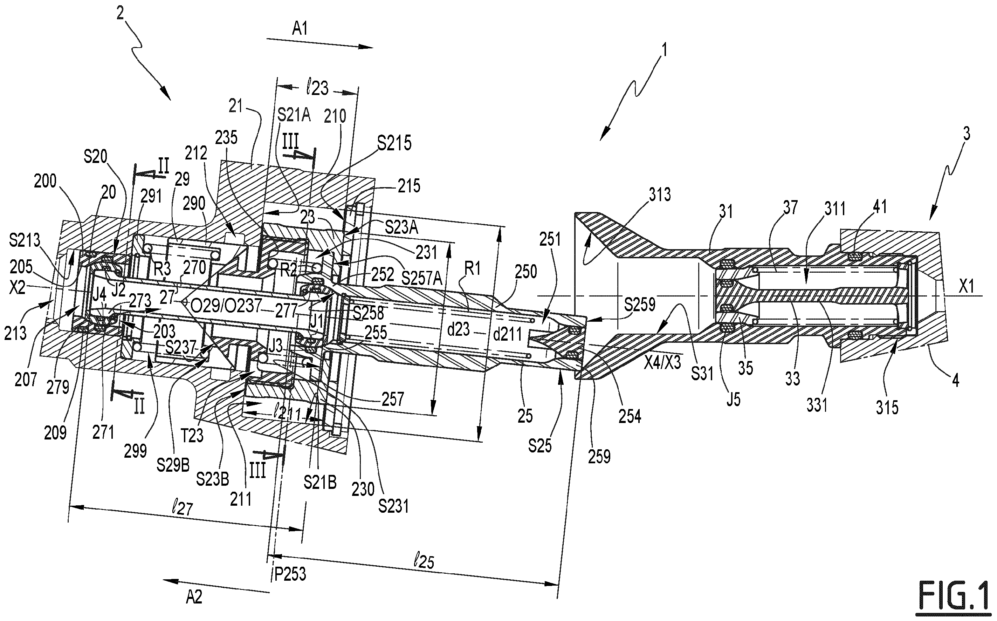

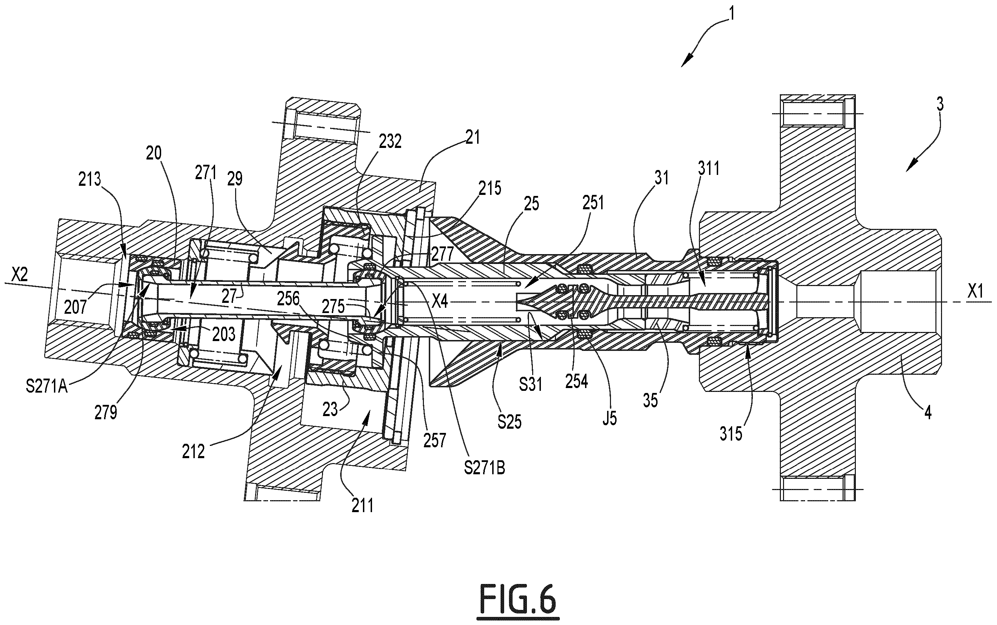

Un ensemble de raccordement fluidique 1, selon un premier mode de réalisation de l'invention, représenté sur les figures 1 à 6 comprend un dispositif de raccordement fluidique 2, ici un dispositif de raccordement fluidique mâle, et un dispositif de raccordement complémentaire 3, ici un dispositif de raccordement femelle. Sur la figure 6 le dispositif de raccordement complémentaire 3 reçoit en emmanchement le dispositif de raccordement fluidique 2, en configuration accouplée.

Le dispositif de raccordement complémentaire 3 comprend un corps principal 31, ici un corps femelle, un piston central 33, une soupape annulaire 35 et un ressort 37.

Le corps principal 31 est tubulaire et traversé de part en part d'un canal interne 311 centré sur un axe longitudinal X1. Le canal interne 311 est délimité par une surface d'embouchure 313 avant tronconique et par une surface radiale interne S31 qui est, avantageusement, étagée, c'est-à-dire présentant plusieurs diamètres internes qui sont croissants en direction de la surface d'embouchure 313.

Le corps principal 31 comprend, en outre, une surface arrière 315 filetée. Le filetage de la surface arrière 315 permet un vissage du corps principal 31 sur un support 4, lui-même relié à une canalisation ou à un tuyau, l'étanchéité de l'assemblage entre le corps principal 31 et le support 4 est assuré par un joint d'étanchéité 41 interposé entre la surface arrière 315 et le support 4.

Le piston central 33 est composé d'un corps 331 de révolution centré sur l'axe longitudinal X1, le corps 331 est monté fixement selon l'axe longitudinal X1 par rapport au corps principal 31 dans le canal interne 311.

La soupape annulaire 35 est montée dans le canal interne 311 et est mobile par rapport au corps principal 31 et au piston 33 selon l'axe longitudinal X1 entre une position avancée de fermeture du canal interne 311 et une position reculée d'ouverture du canal interne 311. Dans sa position avancée, la soupape annulaire 35 coopère de manière étanche avec un siège cylindrique formé sur le corps principal 31 et avec le piston 33.

Le ressort 37 est interposé entre le piston central 33 ou le corps principal 31 et la soupape annulaire 35. Le ressort 37 repousse la soupape annulaire 35 vers sa position avancée.

Le dispositif de raccordement fluidique 2 comporte une bride 23, un embout 25, une tige 27, un support 21 et préférentiellement un coulisseau 20.

Le support 21 comprend un corps de support 210 tubulaire, centrée sur un axe longitudinal X2. Le support 21 comporte une première surface axiale interne avant S21A, perpendiculaire à l'axe longitudinal X2 et une deuxième surface radiale interne S21B cylindrique, centrée sur l'axe longitudinal X2.

Le support 21 comprend un couvercle 215 fixé sur le corps de support 210 par un segment d'arrêt ou, en variante, par vissage. Les première et deuxième surfaces S21A, S21B du support 21 et une surface axiale arrière S215 du couvercle 215, parallèle et opposée à la première surface axiale interne avant S21A, délimitent un logement 211 interne présentant un diamètre interne d211. Le couvercle 215 ferme le logement 211 selon une direction avant A1 parallèle à l'axe longitudinal X2.

Pour la présente description, les termes tels que « axial », « radial » et « longitudinal » sont définis par rapport à l'axe central ou longitudinal de l'élément qu'ils concernent. Par exemple, concernant le support 21, les termes tels que « axial », « radial » et « longitudinal » sont définis par rapport à l'axe X2. Dans ce cas, par exemple, une surface axiale du support 21 s'étend perpendiculairement à l'axe X2, une surface radiale du support 21 s'étend parallèlement à l'axe X2 et autour de l'axe X2. Les termes tels que « avant » et « distal », lorsqu'ils concernent le dispositif de raccordement fluidique 2, se rapportent à la direction avant A1. Les termes tels que « arrière » et « proximal », lorsqu'ils concernent le dispositif de raccordement fluidique 2, se rapportent à une direction arrière A2 opposée à la direction avant A1. Une « surface avant » est tournée dans la direction avant, une « surface arrière » est tournée dans la direction arrière.

Le support 21 comprend également un conduit interne proximal 213 traversant le corps de support 210 et débouchant, dans la direction avant A1, dans le logement 211. Le conduit interne proximal 213 est centré sur l'axe longitudinal X2. Le conduit interne proximal 213 comprend une cavité périphérique 212, ménagée en creux, et une surface radiale interne S213, c'est-à-dire une surface dont la normale en tout point est orthogonale à l'axe longitudinal X2. A l'arrière, le conduit interne proximal 213 est destiné à être relié à un tuyau ou une canalisation. En étant fixe sur le corps de support 210, le couvercle est fixé par rapport au conduit interne proximal 213.

Le coulisseau 20 comprend un corps annulaire 200, centré sur un axe longitudinal, qui, en service, est confondu, à des jeux radiaux près, avec l'axe longitudinal X2 et qui sera donc considéré comme étant l'axe longitudinal X2 par la suite par commodité.

Le coulisseau 20 comprend une surface radiale externe cylindrique S20, qui coopère à jeu radial réduit avec la surface radiale interne S213 du conduit interne proximal 213, et un logement interne 207 en portion de sphère qui sont centrés sur l'axe longitudinal X2 ainsi qu'une ouverture 203 et un épaulement arrière 205. L'ouverture 203 débouche sur l'avant du coulisseau 20 et, sur l'arrière, dans le logement interne 207. L'ouverture 203 est allongée perpendiculairement à l'axe longitudinal X2. L'ouverture 203 présente une largeur L203, mesurée selon une direction orthoradiale à l'axe longitudinal X2, et une hauteur h203, mesurée perpendiculairement à l'axe longitudinal X2 et perpendiculairement à la largeur L203. La hauteur h203 est strictement supérieure à la largeur L203 de l'ouverture 203.

Le coulisseau 20 est logé dans le conduit interne proximal 213 du support 21 et un joint d'étanchéité 209 est interposé radialement entre la surface radiale externe cylindrique S20 du coulisseau 20 et la surface radiale interne S213 du conduit interne proximal 213. Préférentiellement le joint d'étanchéité 209 est porté par la surface radiale externe cylindrique S20 du coulisseau 20 de sorte que le joint d'étanchéité 209 est solidaire selon l'axe longitudinal X5 de la tige 27.

La bride 23 comprend un corps tubulaire 230 centré sur un axe longitudinal X3, qui est parallèle à l'axe longitudinal X2 en configuration montée de la bride 23 dans le support 21. Les directions avant A1 et arrière A2 s'appliquent donc également à l'axe longitudinal X3. De préférence, le corps tubulaire 230 est formé par vissage de plusieurs parties ensemble.

La bride 23 comprend une surface axiale avant externe S23A et une surface axiale arrière externe S23B planes, parallèles entre elles et perpendiculaires à l'axe longitudinal X3. La surface axiale avant externe S23A et la surface axiale arrière externe S23B sont des surfaces annulaires centrées sur l'axe longitudinal X3. La surface axiale avant externe S23A et la surface axiale arrière externe S23B s'étendent au moins partiellement au même niveau radial à l'axe longitudinal X3.

La bride 23 définit également un logement interne 231 centré autour de l'axe longitudinal X3. Le logement interne 231 est délimité par une surface interne S231 tournée selon la direction arrière A2, par un épaulement interne arrière 232, par un lamage 235, par une surface radiale interne arrière et par une surface radiale interne 233 disposée le long de l'axe longitudinal X3 entre la surface interne S231 et l'épaulement interne arrière 232. La surface interne S231 délimite le logement interne 231 dans la direction avant A1. Le logement interne 231 débouche à l'avant de la bride 23 et à l'arrière de la bride 23.

La bride 23 présente, également, des trous T23 faisant communiquer le logement interne 231 de la bride 23 et l'extérieur de la bride 23.

La bride 23 comporte, avantageusement, une protubérance arrière 237 tubulaire qui dépasse de la surface axiale arrière externe S23B de la bride 23 vers l'arrière dans le conduit interne proximal 213 et qui forme la surface radiale interne arrière de la bride 23. Avantageusement, la protubérance arrière 237 forme une surface arrière S237. Avantageusement, la surface arrière S237 est tronconique, convergeant suivant la direction arrière A2 et étant centrée sur l'axe longitudinal X3, et présente une ouverture angulaire 0237.

La bride 23 est montée dans le logement 211 avec la possibilité d'avoir un déplacement radial par rapport au support 21 dans toutes les directions radiales à l'axe longitudinal X2.

Un diamètre externe maximal d23 de la bride 23, mesuré perpendiculairement à l'axe longitudinal X3, est strictement inférieur au diamètre interne d211 du logement 211, avantageusement entre 15% et 25% inférieur au diamètre interne d211 du logement 211, de préférence 20 % inférieur au diamètre interne d211 du logement 211.

Une dimension longitudinale ℓ23 de la bride 23, mesurée parallèlement à l'axe longitudinal X3 entre la surface axiale avant externe S23A et la surface axiale arrière externe S23B de la bride 23, est sensiblement égale à une dimension longitudinale ℓ211 du logement 211, mesurée parallèlement à l'axe longitudinal X2 entre la première surface axiale avant S21A du support 21 et la surface axiale arrière S215 du couvercle 215.

Après assemblage du dispositif de raccordement fluidique 2, les coopérations par contact plan-plan, aux jeux de montage près, entre la surface axiale avant externe S23A et la surface axiale arrière S215 et entre la surface axiale arrière externe S23B et la première surface axiale avant S21A, facilitent et guident le déplacement de la bride 23 dans le logement 211 radialement à l'axe longitudinal X3. En cas de fort déplacement radial de la bride 23 par rapport à l'axe longitudinal X2, la protubérance arrière 237 se loge dans la cavité périphérique 212 du conduit interne proximal 213.

De préférence, la bride 23 est assemblée par vissage de plusieurs parties ensemble. De préférence, la surface axiale avant externe S23A, la surface axiale arrière externe S23B, la surface radiale interne 233 et la surface interne S231 sont formées sur une première partie de la bride 23 tandis que la protubérance 237, l'épaulement 232 et le lamage 235 sont formés sur une deuxième partie de la bride 23 vissée sur la première partie par l'arrière de la première partie. Les première et deuxième parties peuvent être réalisées dans deux matériaux différents, par exemple polymère pour la première partie et métallique pour la deuxième partie. Les trous T23 servent au montage des deux parties de la bride 23 avec un outillage. La bride 23, et notamment la surface axiale avant externe S23A et la surface axiale arrière externe S23B, est dépourvue de joint d'étanchéité. La première surface axiale interne avant S21A et la surface axiale arrière S215 du couvercle 25 sont également dépourvues de joint d'étanchéité. Ainsi aucun joint d'étanchéité n'est interposé directement entre la bride 23 et le support 21 ou le couvercle 215.

L'embout 25 comporte un corps tubulaire 250 mâle, centré sur un axe longitudinal X4, et traversé de part en part le long de l'axe longitudinal X4 par un canal interne distal 251. Le corps tubulaire 250 comprend une surface radiale externe S25 qui est disposée à l'avant du support 21 et qui est, avantageusement, étagée, c'est-à-dire présentant plusieurs diamètres externes qui sont décroissants selon la direction avant A1.

L'embout 25 loge une soupape 254 montée mobile dans le canal interne distal 251 et un ressort R1. La soupape 254 est mobile dans le corps tubulaire 250 de l'embout 25, selon l'axe longitudinal X4, entre une position avancée de fermeture du canal interne distal 251 et une position reculée d'ouverture du passage de fluide dans le canal interne distal 251. La soupape 254 est solidaire du corps tubulaire 250 radialement à l'axe longitudinal X4. La soupape 254 est repoussée vers sa position avancée par le ressort R1 interposé entre une rondelle en appui arrière contre le corps tubulaire 250 et la soupape 254. En position avancée, la soupape 254 coopère de manière étanche avec un siège formé sur une extrémité avant 259 du corps tubulaire 250.

Le corps tubulaire 250 comprend une collerette externe 257 cylindrique disposée au niveau d'une extrémité arrière 252 du corps tubulaire 250. La collerette externe 257 comprend une surface avant S257A et une surface arrière S257B parallèles entre elles et perpendiculaires à l'axe longitudinal X4. Un diamètre externe d257 de la collerette externe 257, centré sur l'axe longitudinal X4, est supérieur aux diamètres de la surface radiale externe S25. Le corps tubulaire 250 comprend également une jupe 256 qui s'étend vers l'arrière à partir de la collerette externe 257 et dont le diamètre externe est inférieur au diamètre externe d257.

La collerette 257 fait face, sur l'avant, à la surface interne S231 et, sur l'arrière, à l'épaulement interne 232. L'embout 25 est donc monté dans la bride 23 avec possibilité de déplacement limité par rapport à la bride 23 selon les directions avant A1 et arrière A2.

L'extrémité arrière 252 de l'embout 25 comprend un logement interne 258 qui débouche dans le canal interne distal 251 selon la direction avant A2 au niveau d'un épaulement avant 255 du corps tubulaire 250. Une ouverture 253 débouche sur l'arrière du corps tubulaire 250 de l'embout 25 et, sur l'avant, dans le logement interne 258. Un plan perpendiculaire P253 à l'axe longitudinal X4, coplanaire avec le plan de coupe III-III, intersecte l'ouverture 253. Le logement interne 258 de l'embout 25 est délimité par une surface interne S258 en portion de sphère centrée sur l'axe longitudinal X4. L'ouverture 253 est allongée perpendiculairement à l'axe longitudinal X4 L'ouverture 253 présente une largeur L253 mesurée dans une direction orthoradiale à l'axe longitudinal X4, et une hauteur h253 mesurée perpendiculairement à l'axe longitudinal X4 et perpendiculairement à la largeur L253.

L'extrémité arrière 252 de l'embout 25 est logée dans le logement interne 231 et est disposée à l'avant de la surface axiale arrière externe S23B. En particulier, en configuration désaccouplée du dispositif de raccordement fluidique 2, la collerette externe 257 est en contact plan-plan avec la surface interne S231 de la bride 23. Le jeu radial de la connexion entre l'embout 25 et la bride 23, qui correspond au jeu radial entre la surface radiale interne 233 et la surface radiale externe de la collerette 257, est inférieur à 1 % au diamètre externe d257 de la collerette externe 257, mesuré perpendiculairement à l'axe longitudinal X4, par exemple pour un diamètre externe d257 de la collerette externe 257 de 24.5mm, le jeu radial est de l'ordre de 0.1 à 0.2 mm. Ainsi le corps tubulaire 250 coopère à jeu radial réduit avec la bride 23 et est montée avec possibilité d'inclinaison dans la bride 23 tout en ayant un mouvement relatif limité avec la bride 23 dans toutes les directions radiales à l'axe longitudinal X3.

Un ressort R2 prend appui sur la bride 23 dans le lamage 235 et sur la surface arrière S257B de la collerette externe 257 de l'embout 25 en étant guidé radialement par la surface radiale externe de la jupe 256. Le ressort R2 repousse la surface avant S257A de la collerette externe 257 de l'embout 25 vers l'avant vers une position dans laquelle la collerette externe 257 est en butée longitudinale avant contre la surface interne S231 de la bride 23, avec l'axe longitudinal X4 de l'embout 25 en position coaxiale, aux jeux radiaux entre la collerette externe 257 et la surface radiale interne 233 de la bride 23 près, avec l'axe longitudinal X2 de la bride 23, position qui est atteinte en configuration désaccouplée. La surface interne S231 de la bride 23 limite le mouvement vers l'avant de l'embout 25 par rapport à la bride 23. L'extrémité arrière 252 de l'embout 25 est solidaire en déplacement avec la bride 23 radialement à l'axe longitudinal X2, aux jeux radiaux près entre la collerette externe 257 et la bride 23.

L'embout 25 dépasse partiellement de la bride 23 et du support 21 selon la direction avant A1 et traverse le couvercle 215. A cet effet, la couvercle 215 présente une ouverture centrale compatible avec les mouvements de la bride 23 et de l'embout 25 par rapport au support 21.

Aucun joint d'étanchéité n'est interposé directement entre la bride 23 et l'embout 25, en particulier entre la surface radiale externe de l'extrémité arrière 252 de l'embout 25 et la bride 25, en particulier entre la collerette 257 et la surface radiale interne 233 de la bride 23. Cela facilite l'inclinaison de l'embout 25 dans la bride 23.

La tige 27 comporte un corps tubulaire 270 centré sur un axe longitudinal X5, monopartite et délimite un canal interne intermédiaire 271 traversant le corps tubulaire 270 de part en part le long de l'axe longitudinal X5. Au niveau d'une extrémité arrière 273 de la tige 27, le canal interne intermédiaire 271 est délimité par une surface interne S271A arrière tronconique et divergeant vers l'arrière et vers l'extérieur du canal interne intermédiaire 271. Au niveau d'une extrémité avant 275 de la tige 27, le canal interne intermédiaire 271 est délimité par une surface interne S271B avant tronconique divergeant vers l'avant et vers l'extérieur du canal interne intermédiaire 271. Le canal interne intermédiaire 271 est dépourvu de soupape ou autres moyens d'obturation.

Une longueur ℓ27 de la tige 27, mesurée parallèlement à l'axe longitudinal X5 entre les extrémités avant 275 et arrière 273 de la tige 27, est, avantageusement, au moins égale à 0.6 fois, de préférence au moins égale à 0.75 fois, une longueur ℓ25 de l'embout 25, mesurée entre une face avant S259 de l'extrémité avant 259 de l'embout 25 et une face arrière de l'embout 25. La longueur ℓ27 de la tige 27 est strictement inférieure à la longueur ℓ25 de l'embout 25. La longueur ℓ27 de la tige 27 permet de limiter l'inclinaison de la tige 27 par rapport à l'embout 25 pour limiter les sollicitations des joints intercalés entre la tige 27 et l'embout 25 en cas de défaut angulaire maximal. Avantageusement, la longueur ℓ27 de la tige 27 est choisie proche de la longueur ℓ25 de l'embout 25 pour limiter l'espace radial nécessaire, dans le support 21 et dans la bride 23, pour l'inclinaison de la tige 27 lorsque le déplacement radial maximal de la bride 23 dans le support 21 est atteint. En pratique, l'inclinaison maximale de la tige 27 par rapport à l'embout 25 est d'environ 6° et l'inclinaison maximale de l'embout 25 par rapport à la bride 23 est d'environ 6°.

La tige 27 comprend une bague avant 277 rapportée autour d'une portion avant 280 du corps tubulaire 270, solidarisée avec le corps tubulaire 270 selon l'axe longitudinal X5 et formant l'extrémité avant 275 de la tige 27. La bague avant 277 forme une surface externe S277 en portion de sphère de diamètre externe d277, centrée sur l'axe longitudinal X5 et s'étendant tout autour de l'axe longitudinal X5 en configuration montée de la bague avant 277 sur le corps tubulaire 270. Un joint d'étanchéité J1 est radialement interposé, par rapport à l'axe longitudinal X5, entre la bague avant 277 et la portion avant 280 du corps tubulaire 270 de la tige 27 et assure la coopération étanche entre le corps tubulaire 270 et la bague 277.

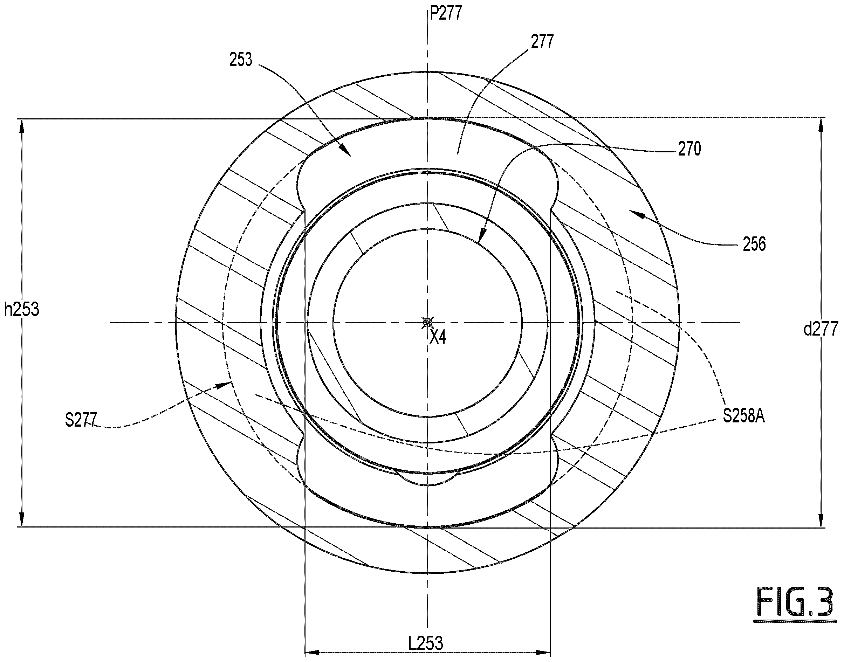

Une épaisseur e277 de la bague avant 277, mesurée parallèlement à l'axe longitudinal X4, en configuration montée de la bague avant 277 dans l'embout 25 et lorsque l'axe longitudinal X4 est coaxial à l'axe longitudinal X5, tel que représenté à la figure 1, est inférieure à la largeur L253 de l'ouverture 253 de l'extrémité arrière 252 de l'embout 25. La largeur L253 est strictement inférieure au diamètre externe d277. Le diamètre externe d277 de la bague avant 277 est inférieur à la hauteur h253 de l'ouverture 253 de l'extrémité arrière 252 de l'embout 25 et strictement supérieur à la largeur L253 de l'ouverture 253. Ainsi la section externe de la bague 277, prise dans un plan longitudinal P277 passant par l'axe longitudinal X4 en configuration montée de la tige 27 dans l'embout 25 et définie par l'épaisseur e277 et le diamètre externe d277, est inférieure à la section de l'ouverture 253 prise dans un plan perpendiculaire à l'axe longitudinal X4, par exemple dans le plan perpendiculaire P253, et définie par la largeur L253 et la hauteur h253. La section de l'ouverture 253 est visible sur la figure 3, sur laquelle le jonc d'arrêt 284 a été omis. La section externe de la bague arrière 277 est visible sur les figures 1 et 4 à 6.

La liaison longitudinale entre le corps tubulaire 270 et l'embout 25 est réalisée par la bague avant 277 intercalée selon l'axe longitudinal X5 entre l'épaulement avant 255 et l'ouverture 253 de l'embout 25. La tige 27 est assemblée à l'embout 25 par engagement de la bague avant 277 dans le logement interne 258 de l'extrémité arrière 252 de l'embout 25 par engagement longitudinal de la bague avant 277 à travers l'ouverture 253 jusque dans le logement interne 258, la bague avant 277 étant orientée de sorte que son épaisseur e277 soit orientée dans un plan perpendiculaire à l'axe longitudinal X4. Cela est possible du fait que la section externe de la bague 277 est plus petite que la section de l'ouverture 253. Puis, dans le logement interne 258, la bague avant 277 est tournée autour d'un axe perpendiculaire à l'axe longitudinal X4 et parallèle à la dimension selon laquelle la hauteur h253 de l'ouverture 253 de l'extrémité arrière 252 de l'embout 25 est maximale, de manière à replacer la bague avant 277 avec son épaisseur e277 parallèle à l'axe longitudinal X4. La bague avant 277 est alors apte à venir en butée arrière contre une surface de butée S258A formée par la surface interne S258 du logement interne 258 et délimitée par l'ouverture 253. Comme visible sur la figure 3, la surface S258A est formée sur un épaulement arrière du corps tubulaire 250 traversé par l'ouverture 253, cet épaulement arrière ne s'étendant pas tout autour de l'axe longitudinal X4 du fait de la présence de l'ouverture 253. La surface S258A est une surface avant. Le corps tubulaire 270 est ensuite engagé dans la bague avant 277 équipée du joint J1, en particulier à travers l'ouverture 253, jusqu'à venir en butée avant contre un épaulement de la bague avant 277 et un jonc d'arrêt 284 est mis en place entre un épaulement externe de la portion avant 275 du corps tubulaire 270 et la bague avant 277 pour limiter le mouvement du corps tubulaire 270 vers l'arrière de la bague avant 277. L'extrémité avant 275 de la tige 27 est donc montée dans l'embout 25 avec possibilité de déplacement limité par rapport à l'embout 25 selon toutes les directions parallèles à l'axe longitudinal X4. En d'autres termes, aux jeux de fonctionnement près, l'extrémité avant 275 de la tige 27 est solidaire de l'extrémité arrière 252 de l'embout 25 le long de l'axe longitudinal X4.

Pendant l'assemblage, un joint d'étanchéité J3 est radialement interposé entre la bague avant 277 et l'extrémité arrière 252 de l'embout 25. Le joint J3 assure la coopération étanche entre l'extrémité avant 275 de la tige 27 et le corps tubulaire 250 quelle que soit la position relative d'inclinaison entre l'embout 25 et la tige 27. La coopération par complémentarité de formes entre la surface externe S277 de la bague avant 277 et la surface interne S258 permet un mouvement d'inclinaison de la tige 27 par rapport à l'embout 25, soit une inclinaison de l'axe longitudinal X5 par rapport à l'axe longitudinal X4 dans tous les plans perpendiculaires à l'axe longitudinal X4. De plus, grâce à la coopération entre la surface externe S277 de la bague avant 277 et la surface interne S258, l'extrémité avant 275 de la tige 27 est montée dans l'embout 25 avec possibilité de déplacement limité par rapport à l'embout 25 dans toutes les directions radiales à l'axe longitudinal X4. En d'autres termes, aux jeux de fonctionnement près, l'extrémité avant 275 de la tige 27 est solidaire de l'extrémité arrière 252 de l'embout 25 radialement à l'axe longitudinal X4 et en particulier solidaire des mouvements de l'embout 25 par rapport au support 21 radialement à l'axe longitudinal X4.

En configuration montée de la tige 27 dans l'embout 25, la tige 27 est en liaison à effet rotule avec l'embout 25 du fait de la coopération des surfaces S277 et S258.

La tige 27 est disposée partiellement dans le logement interne 231 dans la bride 23. En d'autres termes, une partie de la tige 27 est entourée par la bride 23. La tige 27 dépasse partiellement hors de la bride 23 vers l'arrière par rapport à la surface axiale arrière externe S23B et par rapport à la surface arrière S237 et hors de l'embout 25 vers l'arrière par rapport à l'extrémité arrière 252 de l'embout 25.

La tige 27 comprend également une bague arrière 279 rapportée autour de la portion arrière 282 du corps tubulaire 270, solidarisée avec le corps tubulaire 270 selon l'axe longitudinal X5 et formant l'extrémité arrière 273 de la tige 27. La bague arrière 279 forme une surface externe S279 en portion de sphère de diamètre externe d279, centrée sur l'axe longitudinal X5 et s'étendant tout autour de l'axe longitudinal X5 dans une configuration montée de la bague arrière 279 sur le corps tubulaire 270. Un joint d'étanchéité J2 est radialement interposé, par rapport à l'axe longitudinal X5, entre la bague arrière 279 et la portion arrière 282 du corps tubulaire 270 de la tige 27.

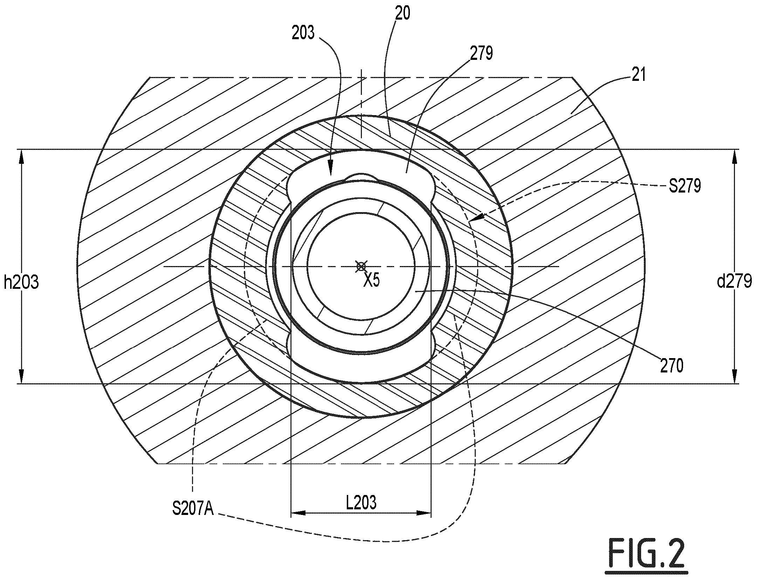

Une épaisseur e279 de la bague arrière 279, mesurée parallèlement à l'axe longitudinal X2, en configuration montée de la tige 27 dans le coulisseau 20 et lorsque l'axe longitudinal X2 est coaxial à l'axe longitudinal X5, tel que représenté à la figure 1, est inférieure à la largeur L203 de l'ouverture 203 du coulisseau 20. La largeur L203 est strictement inférieure au diamètre externe d279.Le diamètre externe d279 de la bague arrière 279, mesuré perpendiculairement à l'axe longitudinal X5, est inférieur à la hauteur h203 de l'ouverture 203 du coulisseau 20. Ainsi la section externe de la bague 279, prise dans un plan longitudinal passant par l'axe longitudinal X2 en configuration montée de la tige 27 dans le coulisseau et définie par l'épaisseur maximale e279 et le diamètre externe d279, est inférieure à la section de l'ouverture 203 prise dans un plan perpendiculaire à l'axe longitudinal X2 et définie par la largeur L203 et la hauteur h203. La section de l'ouverture 203 est visible sur la figure 2, sur laquelle le jonc d'arrêt 286 a été omis. La section externe de la bague arrière 279 est visible sur les figures 1 et 4 à 6.

La liaison longitudinale entre le corps tubulaire 270 et le coulisseau 20 est réalisée par la bague arrière 279 intercalée selon l'axe longitudinal X5 entre l'épaulement arrière 205 et l'ouverture 203 du coulisseau 20. La tige 27 est assemblée au coulisseau 20 par engagement longitudinal de la bague arrière 279 dans le coulisseau 20 jusque dans le logement interne 207 à travers l'ouverture 203, la bague arrière 279 étant orientée de sorte que son épaisseur e279 soit orientée dans un plan perpendiculaire à l'axe longitudinal X2. Cela est possible du fait que la section externe de la bague 279 est plus petite que la section de l'ouverture 203. Puis, dans le logement interne 207, la bague arrière 279 est tournée autour d'un axe perpendiculaire à l'axe longitudinal X2 et parallèle à la dimension selon laquelle la hauteur h203 de l'ouverture 203 du coulisseau 20 est maximale, de manière à replacer la bague arrière 279 avec son épaisseur e279 parallèle à l'axe longitudinal X2. La bague arrière 279 est alors apte à venir en butée avant contre une surface de butée S207A formée par la surface interne du logement interne 207 et délimitée par l'ouverture 203. Le corps tubulaire 270 est ensuite engagé dans la bague arrière 279 équipée du joint J2 jusqu'à venir en butée arrière contre un épaulement de la bague arrière 279 et un jonc d'arrêt 286 est alors mis en place entre un épaulement externe de la portion arrière 273 du corps tubulaire 270 et la bague 279 pour limiter le mouvement du corps tubulaire 270 vers l'avant de la bague arrière 279. L'extrémité arrière 273 de la tige 27 est donc montée dans le coulisseau 20 avec possibilité de déplacement limité par rapport au coulisseau 20 selon les directions avant A1 et arrière A2. En d'autres termes, aux jeux de fonctionnement près, l'extrémité arrière 273 de la tige 27 est solidaire du coulisseau 20 le long de l'axe longitudinal X2.

Pendant l'assemblage, un joint d'étanchéité J4 est radialement interposé entre la bague arrière 279 et le coulisseau 20. La coopération par complémentarité de formes entre la surface externe S279 de la bague arrière 279 et la surface interne du logement interne 207 permet un mouvement d'inclinaison de la tige 27 par rapport au coulisseau 20, et donc par rapport au support 21, soit une inclinaison de l'axe longitudinal X5 par rapport à l'axe longitudinal X2 dans tous les plans perpendiculaires à l'axe longitudinal X2. En particulier, en configuration montée de la tige 27 dans le coulisseau 20, la tige 27 est en liaison à effet rotule avec le coulisseau 20 du fait de la coopération de la surface externe S279 avec la surface interne du logement interne 207.

De plus, grâce à la coopération entre la surface externe S279 de la bague avant 279 et la surface interne du logement interne 207, l'extrémité arrière 273 de la tige 27 est montée dans le coulisseau 20 avec possibilité de déplacement limité par rapport au coulisseau 20 dans toutes les directions radiales à l'axe longitudinal X5. En d'autres termes, aux jeux de fonctionnement près, l'extrémité arrière 273 de la tige 27 est solidaire du coulisseau 20 radialement à l'axe longitudinal X5. En configuration montée de la tige 27 dans le coulisseau 20, quelle que soit la position relative de la tige 27 par rapport au coulisseau 20, le joint J4 assure la coopération étanche entre l'extrémité arrière 273 de la tige 27 et le coulisseau 20 et le conduit interne proximal 213 est en communication fluidique avec le canal interne intermédiaire 271. Une barrière d'étanchéité est ainsi formée pour empêcher la communication fluidique entre le logement 211 ou le logement 231 et le canal interne intermédiaire 271. Plus précisément, uniquement la portion du conduit interne proximal 213 disposée en arrière du joint 209 est en communication fluidique avec le canal interne intermédiaire 271. Cette portion du conduit interne proximal 213 en communication fluidique avec le canal interne intermédiaire 271 est disposée en arrière de la bride 23 et, en particulier, disposée en arrière du dispositif de recentrage 299.

Un diamètre externe d273 de l'extrémité arrière 273 de la tige 27, respectivement un diamètre externe d275 de l'extrémité avant 275 de la tige 27, est strictement inférieur, de préférence au moins 2 fois inférieur, au diamètre externe maximal d23 de la bride 23. Le diamètre externe d273 de l'extrémité arrière 273 de la tige 27, respectivement le diamètre externe d275 de l'extrémité avant 275 de la tige 27, est strictement inférieur au diamètre externe d257 de la collerette externe 257 de l'embout 25.

Le mouvement de la tige 27 le long de l'axe longitudinal X2 est limité, par rapport à l'embout 25 et par rapport au coulisseau 20, respectivement par l'épaulement arrière 205 du coulisseau 20 et la surface de butée S207A et par l'épaulement avant 255 de l'embout 25 et la surface de butée S258A.

L'extrémité arrière 273 de la tige 27 est reçue dans le conduit interne proximal 213 à l'arrière du logement interne 231. En particulier, l'extrémité arrière 273 est disposée au-delà de la bride 23, suivant la direction arrière A2. Le conduit interne proximal 213 reçoit l'extrémité arrière 273 de la tige 27 de manière étanche par l'intermédiaire du coulisseau 20 et des joints d'étanchéité 209 et J4. Une étanchéité arrière est alors formée entre la tige 27 et le support 21 alors que le conduit interne proximal 213 est en communication fluidique avec le canal interne intermédiaire 271.

La bride 23, l'embout 25 et la tige 27 sont, préférentiellement, mis en place dans le corps de support 210 du support 21 par l'avant du corps de support 210 avant vissage ou fixation par segment d'arrêt du couvercle 215 sur le corps de support 210. Avantageusement, le dispositif de raccordement fluidique 2 a une construction compacte radialement.

Le dispositif de raccordement fluidique 2 comprend, avantageusement, un dispositif de recentrage 299 comportant une bague de recentrage 29 et un ressort R3 tous deux logés dans le conduit interne proximal 213 du support 21.

La bague de recentrage 29 comprend un corps annulaire 290, centré sur un axe longitudinal, qui, en service, est confondu, à des jeux radiaux près, avec l'axe longitudinal X2 et qui sera donc considéré comme étant l'axe longitudinal X2 par la suite par commodité.

La bague de recentrage 29 comprend, avantageusement, une surface avant S29A tronconique convergeant vers l'arrière. La surface avant S29A présente une ouverture angulaire 029 similaire à l'ouverture angulaire 0237 de la surface arrière S237 de la protubérance 237.

La bague de recentrage 29 est montée mobile en translation selon l'axe longitudinal X2 dans le conduit interne proximal 213 du support 21 et est guidée radialement par le conduit interne proximal 213. Le jeu radial ne permet pas de mouvement radial à l'axe longitudinal X2 de la bague de recentrage 29 dans le conduit interne proximal 213.

Après assemblage du dispositif de raccordement fluidique 2, la surface avant S29A est en contact surfacique avec la surface arrière S237 de la protubérance 237.

Après assemblage du dispositif de raccordement fluidique 2, le ressort R3 est logé entre, à l'arrière, une bague d'appui 291 en appui arrière contre le support 21 et, à l'avant, une surface arrière S29B de la bague de recentrage 29. Le ressort R3 repousse la surface avant conique S29 en direction de la surface arrière S237 de la bride 23. Le ressort R3, en raison la complémentarité de formes entre la surface avant S29A et la surface arrière S237, exerce un effort radial de rappel élastique de la bride 23 vers une position centrée où l'axe longitudinal X3 est centré sur l'axe longitudinal X2, en particulier centré dans le logement 211 du support 21, aux jeux radiaux entre la collerette externe 257 et la surface radiale interne 233 de la bride 23 près.

Comme montré sur la figure 1 dans une configuration de début d'accouplement, l'axe longitudinal X3 et l'axe longitudinal X1 ne sont pas nécessairement alignés et peuvent présenter un défaut angulaire et/ou radial. Avantageusement les défauts angulaires entre le dispositif de raccordement fluidique 2 et le dispositif de raccordement complémentaire 3 sont de l'ordre de 6° au maximum et les défauts radiaux entre le dispositif de raccordement fluidique 2 et le dispositif de raccordement complémentaire 3 sont de 3.75 mm au maximum.

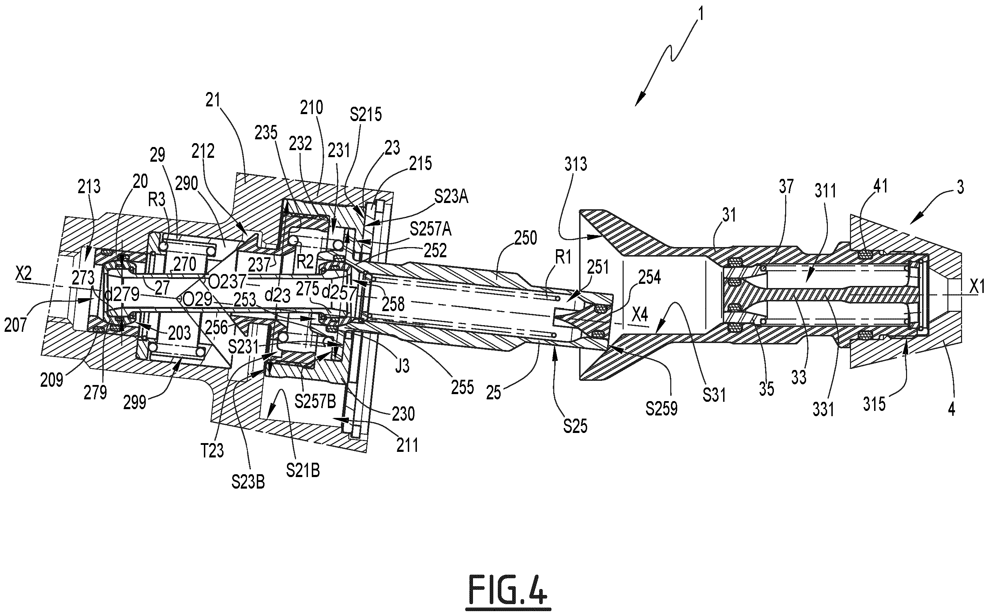

Comme représenté à la figure 4, lorsque les corps femelle 31 et le support 21 sont rapprochés pour atteindre une première configuration intermédiaire d'accouplement, l'extrémité avant 259 de l'embout 25 s'engage dans le corps principal 311 et, par coopération avec la surface d'embouchure 313, est guidée vers l'axe longitudinal X1, ce qui provoque le déplacement radial de la bride 23 dans le support 21, un mouvement d'inclinaison de la tige 27 par rapport à l'embout 25, de la tige 27 par rapport à la bride 23 et de la tige 27 par rapport au support 21. L'extrémité avant 275 de la tige 27 suit en effet le déplacement de l'extrémité arrière 252 de l'embout 25 par rapport au support 21, radialement à l'axe longitudinal X4 de l'embout. Lors de ces mouvements, l'étanchéité reste acquise entre l'embout 25 et le corps tubulaire 270 de la tige 27 et entre le corps tubulaire 270 de la tige 27 et le support 21. Le coulisseau 20 se déplace dans le conduit interne proximal 213 le long de l'axe longitudinal X2. Le ressort R2 maintient la collerette externe 257 en contact surfacique avec la surface interne S231 de la bride 23. Pendant ce déplacement radial de la bride 23 dans le support 21, la surface arrière S29B bouge par rapport à la surface avant S29A, si bien que leur coopération se fait alors par contact ponctuel.

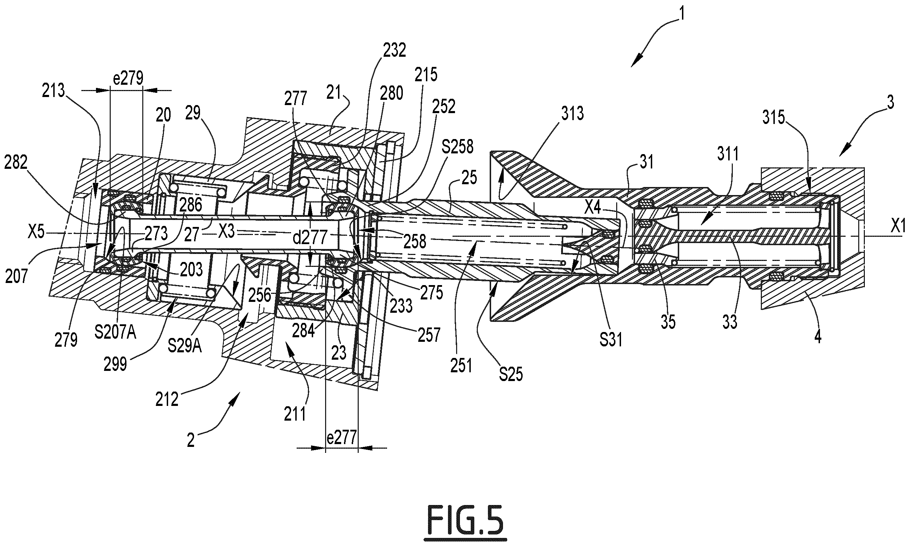

Si le déplacement radial maximal est atteint, c'est-à-dire que la bride 23 rentre en contact radial avec la deuxième surface radiale interne S21B du support 21 alors que l'embout 25 n'est pas coaxial avec l'axe longitudinal X1 du corps principal 31, comme représenté à la figure 5, la poursuite de l'accouplement, pour atteindre une deuxième configuration intermédiaire d'accouplement, va provoquer le mouvement angulaire de l'embout 25 par rapport à la bride 23 à l'encontre du ressort R2, et donc le mouvement angulaire de l'embout 25 par rapport à la tige 27 et le mouvement longitudinal de la tige 27 et du coulisseau 20 par rapport au support 21. Lors de ces mouvements, l'étanchéité reste acquise entre l'embout 25 et le corps tubulaire 270 de la tige 27 et entre le corps tubulaire 270 de la tige 27 et le support 21.

Le mouvement angulaire et/ou longitudinal de la collerette externe 257 de l'embout 25 par rapport à la bride 23 est limité vers l'arrière par l'épaulement interne arrière 232 de la bride 23. L'embout 25 s'aligne alors avec le canal interne 311 du corps principal 31, l'embout 25 est alors en position désalignée vis-à-vis de la bride 23, c'est-à-dire que l'axe longitudinal X3 et l'axe longitudinal X4 sont inclinés l'un par rapport à l'autre. La soupape 254 parvient au contact du piston central 33 du corps principal 31 tandis que la soupape annulaire 35 du corps principal 31 parvient au contact du corps tubulaire 250 de l'embout 25, la soupape 254 et la soupape annulaire 35 du corps principal 31 étant respectivement repoussées à l'encontre de leur ressort vers leur position reculée pour permettre le passage de fluide entre le conduit interne proximal 213 du support 21 et le canal interne 311 du corps principal 31, via le canal interne intermédiaire 271 de la tige 27 et via le canal interne distal 251 de l'embout 25. La surface radiale externe S25 de l'embout 25 vient en coopération étanche avec la surface radiale interne S31 du corps principal 31 via un joint d'étanchéité J5 porté par la surface radiale interne S31 avant que la soupape 254, respectivement la soupape annulaire 35, ne perde l'étanchéité avec le corps tubulaire 250, respectivement le corps principal 31. La configuration accouplée, représenté à la figure 6, est atteinte pour un rapprochement prédéterminé du corps femelle 31 et du support 21. L'embout 25 est accouplé fluidiquement au dispositif de raccordement fluidique complémentaire 3. L'emmanchement de l'embout 25 dans le corps principal 31 est, avantageusement, facilité par la coopération par complémentarité de formes, c'est-à-dire par complémentarité de leurs diamètres, entre la surface radiale interne S31 du corps principal 31 et la surface radiale externe S25 de l'embout 25 permettant un guidage sans coincement.

Lors du désaccouplement, une séquence inverse des mouvements se produit. Dès que l'embout 25 coopère avec la surface d'embouchure 313, le ressort R2 peut repousser la collerette externe 257 en contact surfacique avec la bride 23, pour ramener l'embout 25 en position alignée avec la bride 23, avec l'axe longitudinal X3 parallèle, voire coaxiale avec l'axe longitudinal X4.

Grâce au dispositif de recentrage 299 et au ressort R2, en configuration désaccouplée, l'axe longitudinal X3 est recentré sur l'axe longitudinal X2 et l'axe longitudinal X4 est recentré sur l'axe longitudinal X3, c'est-à-dire que la bride 23 est en position centrée dans le logement 211 et que le corps tubulaire 250 de l'embout 25 est en position centrée, dans le logement interne 231, aux jeux radiaux entre la collerette externe 257 et la bride 23 près, ce qui permet d'augmenter le défaut d'alignement entre le dispositif de raccordement fluidique 2 et le dispositif de raccordement fluidique complémentaire 3 admissible par l'ensemble de raccordement fluidique 1 au début de l'accouplement, et donc de diminuer la taille de la surface d'embouchure 313 du dispositif de raccordement fluidique complémentaire 3.

La séquence d'accouplement peut d'abord se produire avec le mouvement angulaire de l'embout 25 par rapport à la bride 23 puis ensuite avec le déplacement radial de la bride 23 dans le support 21, ou avec une combinaison du mouvement angulaire de l'embout 25 par rapport à la bride 23 avec un déplacement radial de la bride 23 dans le support 21, en fonction de la force développée par le ressort R2 sur l'embout 25, de la force développée par le ressort R3 sur la bride 23 et des efforts de pression du fluide à l'intérieur du dispositif de raccordement fluidique 2.

Dans toutes les configurations, la totalité des surfaces de la bride 23 sont isolées fluidiquement du canal interne distal 251 de l'embout 25 et du canal interne intermédiaire 271 de la tige 27. Dans toutes les configurations, l'extrémité avant 277 de la tige 27 est en coopération étanche avec l'extrémité arrière 252 de l'embout 25 et le conduit interne proximal 213 est en communication fluidique avec le canal interne distal 251 via le canal interne intermédiaire 271.

En variante non représentée, le rappel de la bride 23 en position centrée dans le logement 211 du support 21 est réalisé par un élément déformable, avantageusement un élastomère ou un ressort, interposé entre la tige 27 et le support 21 ou entre la bride 23 et le support 21.

En variante non représentée, la tige 27 est montée autour de l'embout 25, au lieu d'être monté dans un logement interne de l'embout 25, la tige 27 est montée autour de l'embout 25 de manière étanche, avec possibilité d'inclinaison par rapport à l'embout 25 et avec possibilité de déplacement limité selon toutes les directions parallèles à l'axe longitudinal de l'embout.

En variante non représentée, une seule surface parmi la surface avant S29A de la bague de recentrage 29 et la surface arrière S237 de la bride 23 est tronconique, l'autre surface est aménagée pour venir en contact avec la surface conique, en étant par exemple une surface arrondie.

En variante non représentée, la bride 23 est commune à plusieurs embouts, de préférence deux embouts, la bride 23 comprenant alors autant de logements internes 231 distincts, le support comprenant alors autant de conduits internes proximal 213 distincts, chaque conduit interne du support recevant de manière étanche une tige qui est monté de manière étanche avec l'embout respectif avec possibilité d'inclinaison relative.

En variante non représentée, l'étanchéité arrière entre la tige 27 et le support 21 est réalisée par un joint d'étanchéité logé dans une gorge ménagée dans la surface radiale interne S213 du conduit interne proximal 213 et coopérant avec le coulisseau 20.

En variante non représentée, le dispositif de raccordement fluidique 2 ne comporte pas de soupape et/ou le dispositif de raccordement fluidique complémentaire 3 ne comporte pas non plus de soupape.

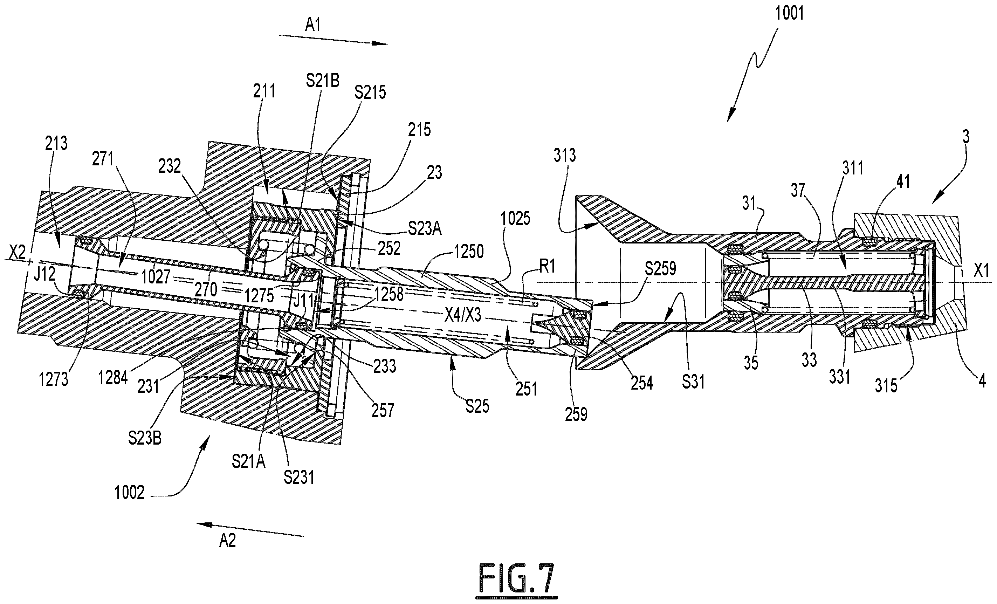

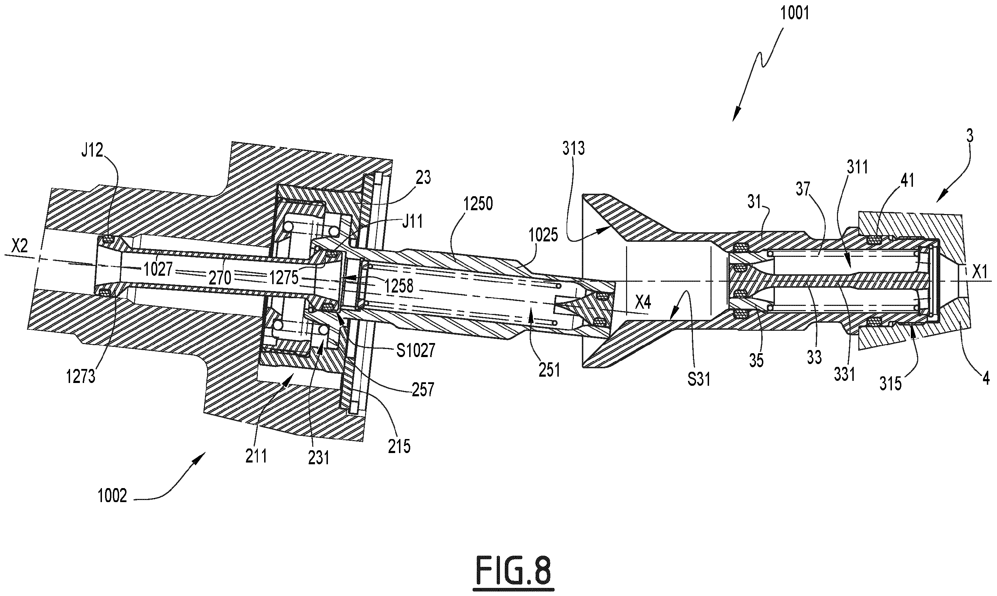

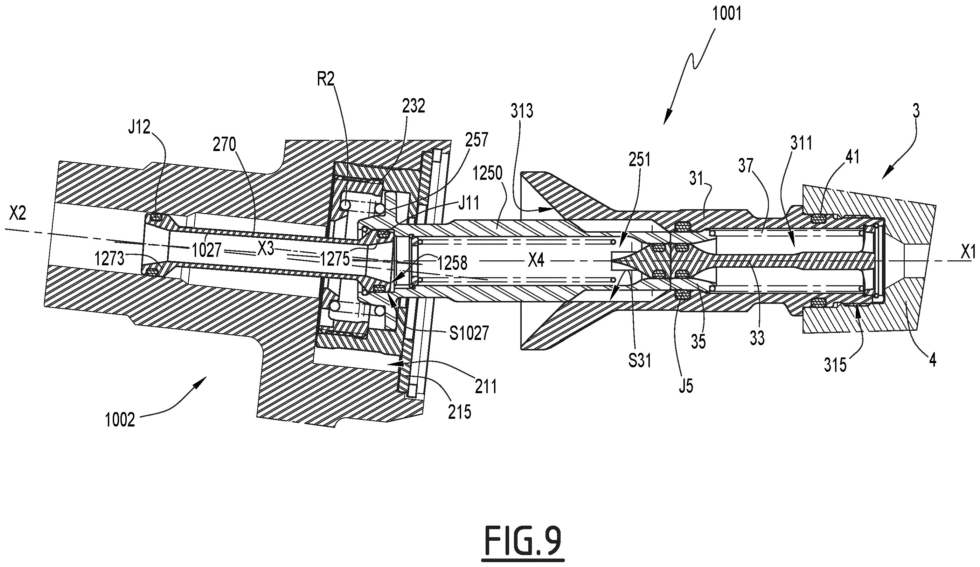

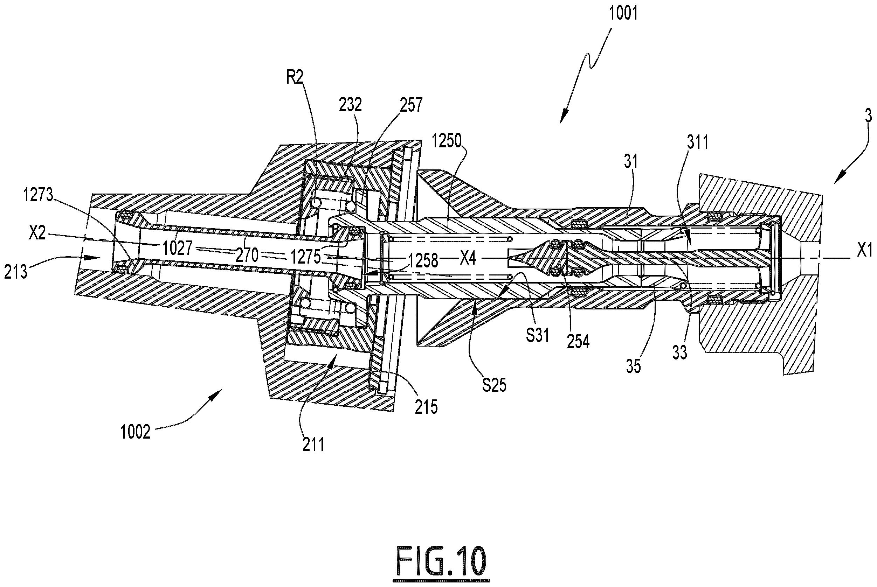

Les figures 7 à 10, illustrent un ensemble de raccordement fluidique 1001 selon un deuxième mode de réalisation de l'invention, l'ensemble de raccordement fluidique 1001 étant identique à l'ensemble de raccordement 1 du premier mode de réalisation sauf pour les caractéristiques décrites ci-après. Les signes de référence pour le dispositif de raccordement fluidique 1001 correspondent à ceux du dispositif de raccordement fluidique 1 lorsque que l'élément référencé est inchangé. Les signes de référence sont augmentés de 1000 lorsqu'ils désignent des éléments similaires mais modifiés dans le dispositif de raccordement 1001.

Le corps tubulaire 1250 mâle comprend un logement interne 1258 cylindrique qui débouche sur l'arrière du corps tubulaire 1250 et qui est destiné à coopérer avec le corps tubulaire 270 de la tige 1027 via un joint d'étanchéité J11 logé dans la surface radiale externe S1027 de l'extrémité avant 1275 de la tige 1027. La tige 1027 est montée dans le logement interne 1258 du corps tubulaire 1250 par un segment d'arrêt 1284 qui limite le mouvement relatif longitudinal entre l'embout 1025 et de la tige 1027 mais qui autorise une inclinaison de la tige 1027 par rapport à l'embout 1025. En effet, les dimensions radiales de l'extrémité avant 1275 de la tige 1027 et du logement interne 1258 autorisent l'inclinaison de l'axe longitudinal X4 par rapport à l'axe longitudinal X5. L'extrémité avant 1275 de la tige 1027 est donc montée dans l'embout 1025 avec possibilité de déplacement limité par rapport à l'embout 1025 selon toutes les directions parallèles à l'axe longitudinal X4 et selon toutes les directions radiales à l'axe longitudinal X4, de manière à permettre l'inclinaison de la tige 1027 par rapport à l'embout 1025 tout en maintenant l'extrémité avant 1275 dans l'embout 1025. En d'autres termes, aux jeux de fonctionnement près, l'extrémité avant 1275 de la tige 1027 est solidaire de l'extrémité arrière 1252 de l'embout 1025 le long de l'axe longitudinal X4 et radialement à l'axe longitudinal X4. En configuration montée de la tige 1027 dans l'embout 1025, quelle que soit leur position relative, le joint J11 assure la coopération étanche entre l'extrémité avant 1275 de la tige 1027 et l'embout 1025 et le canal interne distal 251 est en communication fluidique avec le canal interne intermédiaire 271. L'extrémité arrière 1273 du corps tubulaire 270 de la tige 1027 coopère avec la surface délimitant le conduit interne proximal 213 via un joint d'étanchéité J12 monté dans la tige 1027, donc solidaire de la tige 1027 le long de l'axe longitudinal X2, et interposé radialement directement entre le corps tubulaire 270 et le conduit interne proximal 213. Le joint J12 assure la coopération étanche entre l'extrémité arrière 1273 de la tige 1027 et le support 21 quelle que soit leur position relative. Ainsi les bagues avant et arrière et le coulisseau sont supprimés dans ce mode de réalisation.

En configuration désaccouplée, comme le dispositif de raccordement fluidique 1002 ne comprend pas de dispositif de recentrage, la bride 23 n'est pas forcément en position centrée dans le logement 211 du support 21, comme illustré à la figure 7, sa position dans le logement 211 du support 21 pouvant dépendre d'une précédente séquence d'accouplement.

La séquence d'accouplement est identique à celle décrite pour le premier mode de réalisation. Au désaccouplement, la bride 23 reste dans sa position relative dans le logement 211 du support 21.

Cette construction admet également des défauts d'alignement angulaires et radiaux entre les dispositifs de raccordement à accoupler.

Toute caractéristique décrite ci-avant pour un mode de réalisation ou une variante est applicable aux autres modes de réalisation et variantes décrits ci-avant, pour autant que cela est techniquement possible.

## Revendications

1. Dispositif de raccordement fluidique (2 ; 1002), comprenant :
- une bride (23), formant une surface axiale avant externe (S23A) et une surface axiale arrière externe (S23B), opposée à la surface axiale avant externe (S23A), la surface axiale avant externe (S23A) et la surface axiale arrière externe (S23B) étant annulaires, perpendiculaires à un axe longitudinal (X3) central de la bride (23), et tournées respectivement suivant une direction avant (A1) parallèle à l'axe longitudinal (X3) de la bride (23), suivant une direction arrière (A2) opposée à la direction avant (A1) ; et
- au moins un embout (25 ; 1025) centré sur un axe longitudinal (X4), traversé par un canal interne distal (251) et configuré pour être accouplé fluidiquement à un dispositif de raccordement complémentaire (3), l'embout (25 ; 1025) comportant :
∘ une extrémité arrière (252), montée dans un logement interne (231) de la bride (23), et
∘ une extrémité avant (259), disposée au-delà de la surface axiale avant externe (S23A) de la bride (23) selon la direction avant (A1);
l'embout (25 ; 1025) étant monté dans la bride (23) :
∘ avec possibilité d'inclinaison par rapport à la bride (23),et
∘ avec possibilité de déplacement limité par rapport à la bride (23) selon les directions avant (A1) et arrière (A2) et selon toutes les directions radiales à l'axe longitudinal (X3) de la bride (23),
l'extrémité arrière (252) de l'embout (25 ; 1025) étant solidaire en déplacement avec la bride (23) radialement à l'axe longitudinal (X3), aux jeux radiaux près entre une collerette externe (257) de l'embout (25 ; 1025) et la bride (23), la collerette externe (257) étant cylindrique et disposée au niveau de l'extrémité arrière (252) de l'embout (25);
- un couvercle (215), qui forme une surface axiale arrière (S215) apte à coopérer avec la surface axiale avant externe (S23A) de la bride (23) pour guider un déplacement de la bride (23) par rapport au couvercle (215) radialement à l'axe longitudinal (X3) de la bride (23),
**caractérisé en ce que** le dispositif de raccordement fluidique (2) comprend une tige (27 ; 1027) comportant :
- un canal interne intermédiaire (271);
- une extrémité avant (275 ; 1275), montée en coopération étanche avec l'extrémité arrière (252) de l'embout (25 ; 1025) avec possibilité d'inclinaison de la tige (27) par rapport à l'embout (25 ; 1025) et par rapport à la bride (23), l'extrémité avant (275 ; 1275) de la tige (27 ; 1027) étant solidaire de l'extrémité arrière (252) de l'embout (25 ; 1025) le long de l'axe longitudinal (X4) de l'embout (25 ; 1025), aux jeux de fonctionnement près, et l'extrémité avant (275 ; 1275) de la tige (27 ; 1027) étant solidaire de l'extrémité arrière (252) de l'embout (25 ; 1025) radialement à l'axe longitudinal (X4) de l'embout (25 ; 1025), aux jeux de fonctionnement près, pour une communication fluidique entre le canal interne distal (251) de l'embout (25 ; 1025) et le canal interne intermédiaire (271) de la tige (27 ; 1027); et
- une extrémité arrière (273 ; 1273) disposée au-delà de la bride (23), suivant la direction arrière (A2) pour une communication fluidique entre le canal interne intermédiaire (271) de la tige (27 ; 1027) et un conduit interne proximal (213), par rapport auquel le couvercle (215) est destiné à être fixe;
le canal interne intermédiaire (271) traversant la tige (27 ; 1027) depuis l'extrémité avant (275 ; 1275) de la tige (27 ; 1027) jusqu'à l'extrémité arrière (273 ; 1273) de la tige (27 ; 1027).

2. Dispositif de raccordement fluidique (2 ; 1002) selon la revendication 1, dans lequel l'extrémité avant (275 ; 1275) de la tige (27 ; 1027) est reçue de manière étanche dans un logement interne (258 ; 1258) de l'extrémité arrière (252) de l'embout (25 ; 1025).

3. Dispositif de raccordement fluidique (2) selon la revendication 2, dans lequel la tige (27) comprend un corps tubulaire (270) et une bague avant (277) qui entoure de manière étanche le corps tubulaire (270) de la tige (27) pour former l'extrémité avant (275) de la tige (27) et qui, dans une configuration montée de la tige (27) dans le logement interne (258) :
- présente une surface externe (S277) en portion de sphère qui coopère par complémentarité de formes avec une surface interne (S258) en portion de sphère du logement interne (258 ; 1258) de l'extrémité arrière (252) de l'embout (25) ; et
- est apte à venir en butée arrière contre une surface de butée (S258A) formée par la surface interne (S258) partiellement sphérique du logement interne (258) et délimitée par une ouverture (253) de l'embout (25) débouchant sur l'arrière de l'embout (25) et, sur l'avant, dans le logement interne (258) de l'embout (25),
ladite ouverture (253) s'étendant, dans un plan perpendiculaire (P253) à l'axe longitudinal (X4) de l'embout (25), sur une section plus grande que la section externe de la bague avant (277), prise dans un plan longitudinal (P277) passant par l'axe longitudinal (X4) de l'embout (25) et en configuration montée de la tige (27) dans le logement interne (258).

4. Dispositif de raccordement fluidique (2 ; 1002) selon l'une quelconque des revendications précédentes, dans lequel aucun joint d'étanchéité n'est interposé directement entre la bride (23) et l'embout (25 ; 1025).

5. Dispositif de raccordement fluidique (2 ; 1002) selon l'une quelconque des revendications précédentes, comprenant un premier ressort (R2), qui est interposé entre la bride (23) et l'embout (25 ; 1025) et qui rappelle élastiquement l'embout (25 ; 1025) par rapport à la bride (23), vers une position où la collerette externe (257) de l'embout (25 ; 1025) est en butée avant contre une surface interne (S231) de la bride (23) délimitant le logement interne (231), et l'axe longitudinal (X3) de la bride (23) est coaxial avec l'axe longitudinal (X4) de l'embout (25 ; 1025).

6. Dispositif de raccordement fluidique (2 ; 1002) selon l'une quelconque des revendications précédentes, comportant un corps de support (210), avec lequel est fixé le couvercle (215) et qui forme :
- une surface axiale avant (S21A) qui délimite, avec la surface axiale arrière (S215) du couvercle (215), un logement (211) recevant la bride (23), la surface axiale avant (21A) étant apte à guider le déplacement de la bride (23) par rapport au corps de support (210), radialement à l'axe longitudinal (X3) de la bride (23), par coopération avec la surface axiale arrière externe (S23B) de la bride (23) ; et
- le conduit interne proximal (213), qui est centré sur un axe longitudinal central (X2), qui débouche dans le logement (211) du corps de support (210) selon la direction avant (A1), et qui reçoit l'extrémité arrière (273 ; 1273) de la tige (27; 1027) pour la communication fluidique entre le canal interne intermédiaire (271) de la tige (27 ; 1027) et le conduit interne proximal (213).

7. Dispositif de raccordement fluidique (2) selon la revendication 6, comportant un dispositif de recentrage (299), rappelant élastiquement la bride (23) vers une position où l'axe longitudinal (X3) de la bride (23) est coaxial avec l'axe longitudinal central (X2) du conduit interne proximal (213).

8. Dispositif de raccordement fluidique (2) selon la revendication 7, dans lequel le dispositif de recentrage (299) comprend :
- une bague de recentrage (29), agencée dans le conduit interne proximal (213) et mobile en translation par rapport au corps de support (210) suivant l'axe longitudinal central (X2) du conduit interne proximal (213); et
- un deuxième ressort (R3), repoussant une surface avant (S29A) de la bague de recentrage (S29) en contact avec une surface arrière (S237) de la bride (23) ;
et dans lequel la surface arrière (S237) de la bride (23) est une surface tronconique centrée sur l'axe longitudinal (X3) de la bride (23) et/ou la surface avant (S29A) de la bague de recentrage (29) est une surface tronconique centrée sur l'axe longitudinal central (X2) du conduit interne proximal (213).

9. Dispositif de raccordement fluidique (2 ; 1002) selon l'une quelconque des revendications 6 à 8, comprenant un joint d'étanchéité (209 ; J12), solidaire de la tige (27 ; 1027) selon l'axe longitudinal central (X2) du conduit interne proximal (213) et en contact étanche avec une surface radiale interne (S213) du conduit interne proximal (213) du corps de support (210).

10. Dispositif de raccordement fluidique (2) selon l'une quelconque des revendications 6 à 9, dans lequel l'extrémité arrière (273) de la tige (27) est montée dans un coulisseau (20) :
- de manière étanche,
- avec possibilité d'inclinaison par rapport au coulisseau (20),
dans lequel l'extrémité arrière (273) de la tige (27) est solidaire du coulisseau (20) le long de l'axe longitudinal (X2) du conduit interne proximal (213), aux jeux de fonctionnement près, et l'extrémité arrière (273) de la tige (27) est solidaire du coulisseau (20) radialement à un axe longitudinal (X5) de la tige (27), aux jeux de fonctionnement près, et
dans lequel le coulisseau (20) comporte une surface radiale externe cylindrique (S20) et est monté dans le conduit interne proximal (213) avec possibilité de déplacement par rapport au corps de support (210) le long de l'axe longitudinal central (X2) du conduit interne proximal (213).

11. Dispositif de raccordement fluidique (2 ; 1002) selon l'une quelconque des revendications précédentes, dans lequel le canal interne intermédiaire (271) de la tige (27) est délimité par une surface interne (S271A, S271B), tronconique évasée vers l'extérieur du canal interne intermédiaire (271) à l'extrémité avant (275 ; 1275) de la tige (27), respectivement à l'extrémité arrière (273 ; 1273) de la tige (27).

12. Dispositif de raccordement fluidique (2 ; 1002) selon l'une quelconque des revendications précédentes, dans lequel une longueur (ℓ27) de la tige (27), mesurée entre l'extrémité avant (275 ; 1275) et l'extrémité arrière (273 ; 1273) de la tige (27) selon un axe longitudinal (X5) de la tige (27), est strictement inférieure à une longueur (ℓ25) de l'embout (25 ;1025), mesurée entre l'extrémité avant (259) et l'extrémité arrière (252) de l'embout (25 ;1025) selon l'axe longitudinal (X4) de l'embout (25 ; 1025).

13. Dispositif de raccordement fluidique (2 ; 1002) selon l'une quelconque des revendications précédentes, comprenant une soupape (254) disposée dans le canal interne distal (251) de l'embout (25 ;1025), qui est mobile par rapport à l'embout (25 ;1025) le long de l'axe longitudinal (X4) de l'embout (25 ; 1025) entre une position avancée de fermeture du canal interne distal (251) et une position reculée d'ouverture du canal interne distal (251).

14. Ensemble de raccordement fluidique (1 ; 1001), comprenant le dispositif de raccordement fluidique (2 ; 1002) selon l'une quelconque des revendication 1 à 13 et le dispositif de raccordement complémentaire (3 ; 1003), configuré pour s'accoupler avec l'embout (25 ; 1025) du dispositif de raccordement fluidique (2 ; 1002).

15. Ensemble de raccordement fluidique (1 ; 1001) selon la revendication 14, dans lequel le dispositif de raccordement complémentaire (3 ; 1003) comprend un corps principal (31), comprenant une surface radiale interne (S31) étagée, dans lequel l'embout (25 ; 1025) comprend une surface radiale externe (S25) étagée et dans lequel la surface radiale interne (S31) étagée et la surface radiale externe (S25) étagée coopèrent, en configuration accouplée, par complémentarité de formes.
